(19) **Europäisches Patentamt**
**European Patent Office**
**Office européen des brevets**

(11) **EP 4 575 524 B1**

(12) **EUROPEAN PATENT SPECIFICATION**

(45) Date of publication and mention
of the grant of the patent:
**03.12.2025 Bulletin 2025/49**

(21) Application number: **23217570.3**

(22) Date of filing: **18.12.2023**

(51) International Patent Classification (IPC):
***G01R 15/20*** *(2006.01)*

(52) Cooperative Patent Classification (CPC):
**G01R 15/207**

(54) **METHOD AND SENSOR DEVICE FOR DETERMINING AN ELECTRICAL CURRENT FLOWING IN A CONDUCTOR AND CURRENT MEASURING SYSTEM**

VERFAHREN UND SENSORVORRICHTUNG ZUM ERMITTELN EINES IN EINEM LEITER FLIESSENDEN ELEKTRISCHEN STROMS UND STROMMESSSYSTEM

PROCÉDÉ ET DISPOSITIF DE DÉTECTION POUR DÉTERMINER UN COURANT ÉLECTRIQUE CIRCULANT DANS UN CONDUCTEUR ET SYSTÈME DE MESURE DE COURANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**25.06.2025 Bulletin 2025/26**

(73) Proprietor: **maglab AG**
**6300 Zug (CH)**

(72) Inventors:
• **Bilbao de Mendizabal, Javier**
**6300 Zug (CH)**
• **Roos, Markus**
**6300 Zug (CH)**

(74) Representative: **Liesegang, Eva**
**Boehmert & Boehmert**
**Anwaltspartnerschaft mbB**
**Pettenkoferstrasse 22**
**80336 München (DE)**

(56) References cited:
**US-A1- 2014 103 929    US-B2- 8 954 293**

• **LUCA DI RIENZO ET AL: "Circular Arrays of Magnetic Sensors for Current Measurement", IEEE TRANSACTIONS ON INSTRUMENTATION AND MEASUREMENT, IEEE, USA, vol. 50, no. 5, 1 October 2001 (2001-10-01), XP011025357, ISSN: 0018-9456**

## Description

### Field

Examples and aspects relate in general to the field of current sensors. More particularly, some examples and aspects relate to a method and a sensor device for determining an electrical current flowing in a conductor. Some examples and aspects also relate to a current measuring system.

### Background

Sensor devices that estimate an electric current flowing in a conductor are generally known in the art. An electric current flowing in a conductor produces a magnetic field. The current in the conductor may be determined by magnetic sensors placed nearby and sensing the related magnetic field generated by the current. The current measurement is based on the principles of Maxwell's equations, which provide that the magnitude of the magnetic field generated by the flow of current in the conductor is inversely proportional to a distance from the center of the conductor to the point of measurement, and proportional to the current flowing in the conductor. For example, US 2017/0184635 A1 describes a sensing apparatus for characterizing current flow through a conductor which includes a plurality of magnetic sensors. The prior art paper "Circular Arrays of Magnetic Sensors for Current Measurement", by Rienzo et al, IEEE TRANSACTIONS ON INSTRUMENTATION AND MEASUREMENT, IEEE, USA, vol. 50, no. 5, 1 October 2001, XP011025357, discloses a current sensor using a plurality of magnetic sensors arranged around a busbar, and whose outputs are combined to get a current estimate. D1 mentions that multipole expansion (MPE) may be used in case of cross-talk from other nearby conductors, but teaches no mapping, predetermined MPE coefficients, nor any reference point associated with the busbar.

### Summary

A fundamental challenge for such sensor devices and systems is their long-term stability. An initially sufficiently accurate calibration of the sensor device or system changes over time, e.g., by mechanical displacement or misalignment of the components relative to one another or by drifting of electronic sensor properties.

Furthermore, such a sensor device may be responsive to external fields, e.g., magnetic fields generated by other/neighboring current-carrying conductors (i.e., crosstalk), stray magnetic fields of other/neighboring magnetic components, the earth's magnetic field, and the like. Without countermeasures, these additional field components cannot be distinguished from the useful field so that the external fields restrict the accuracy of the sensor device or system.

Accordingly, there is a need for a method, a sensor device, and a current measuring system for determining an electrical current flowing in a conductor, which are distinguished by improved performance, where performance is assessed inter alia on the qualities of operational robustness, numerical precision, long-term stability, application flexibility, and production/implementation ease and cost.

Among others, one object is to provide a method, a sensor device, and a current measuring system for determining an electrical current flowing in a conductor, which ensure high operational robustness and long-term stability, for example, low susceptibility to interference due to external fields unrelated to the current flow in the conductor such as those mentioned above (e.g., stray fields, crosstalk etc.) and low susceptibility to displacement or misalignment of the components relative to one another, while providing accurate and reliable measurement results. The adaptability of the method, the device and the measuring system to different use cases and requirements shall also be improved, and the complexity and cost of manufacturing and implementation be reduced, for example, by not requiring shielding or magnetic cores.

The examples, embodiments, and aspects are defined by the independent claims. The dependent claims define advantageous embodiments.

It is to be noted that the individual features listed in the description below can be combined in any technically meaningful way with each other (also across different categories, e.g., apparatus and method) and show further embodiments. The description of various examples, embodiments, and aspects are additionally characterized and specified particularly in connection with the figures.

Furthermore, it is to be understood that the term "and/or" or the expressions "at least one of" or "one or more of", if used herein in order to combine a first and a second feature, are to be construed as disclosing a first embodiment that comprises only the first feature, a second embodiment that comprises only the second feature, and a third embodiment comprises both the first feature and the second feature. If more than two features are listed, also any combinations thereof are to be construed as disclosed embodiments.

Still further, the terms "approximately", "essentially", or "about" indicate a range of tolerance which the skilled person in the field in question considers to be normal. In particular, the aforementioned terms are to be understood as encompassing a tolerance range of the referred quantity of up to a maximum of +/-20 %, preferably up to a maximum of +/-10 %.

Certain examples, embodiments, and aspects will be described, in many cases with reference to certain drawings, but the claimed subject matter is limited only by the claims.

The terms "first", "second", and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments described herein are capable of operation in other sequences than described or illustrated herein.

Moreover, directional terminology such as top, bottom, front, back, leading, trailing, under, over, and the like in the description and the claims is used for descriptive purposes with reference to the orientation of the drawings being described, and not necessarily for describing absolute positions. Because components of embodiments can be positioned in a number of different orientations, the directional terminology is used for purposes of illustration only, and is in no way intended to be limiting, unless otherwise indicated. It is, hence, to be understood that the terms so used are interchangeable under appropriate circumstances and that the embodiments described herein are capable of operation in other orientations than described or illustrated herein.

It is to be noticed that the term "comprising" used in the claims should not be interpreted as being restricted to the elements listed thereafter. It does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising features A and B" should not be limited to devices consisting only of features A and B. It means that with the device may include additional elements or features of the device are A and B.

Reference throughout this specification to "one embodiment" or "an embodiment" means that a particular feature, structure or characteristic described in connection with the embodiment is included in at least one embodiment. Thus, appearances of the phrases "in one embodiment" or "in an embodiment" in various places throughout this specification are not necessarily all referring to the same embodiment but may. Furthermore, the particular features, structures or characteristics may be combined in any suitable manner, as would be apparent to one of ordinary skill in the art from this disclosure, in one or more embodiments.

Similarly, it should be appreciated that in the description of example embodiments, various features are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed subject matter requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment.

Furthermore, while some embodiments described herein include some but not other features included in other embodiments, combinations of features of different embodiments are meant to be within the scope of the disclosure, and form different embodiments, as would be understood by those in the art. For example, in the following claims, any of the claimed embodiments can be used in any combination.

In the description provided herein, numerous specific details are set forth. However, it is understood that embodiments may be practiced without these specific details. In other instances, well-known methods, structures and techniques have not been shown in detail in order not to obscure an understanding of this description.

According to one example, a method for determining a current flowing in a conductor (e.g., a cable, a busbar, and the like) comprises the steps of:

- providing a number of magnetic sensor elements (e.g., analog or digital sensor elements such as Hall elements, circular Hall elements, horizontal Hall elements, vertical Hall elements, magneto-resistive (MR) elements, AMR elements, XMR elements, GMR elements, TMR elements, etc.), which are sensitive to a magnetic field generated by the current, at respective sensor locations relative to a predetermined reference point (herein also referred to as "the origin of the multipole expansion"),
- outputting, by the magnetic sensor elements, sensor signals indicative of a characteristic of the magnetic field at the respective sensor locations, e.g., a magnetic field component oriented in a particular direction;
- receiving the sensor signals from the magnetic sensor elements or from a circuit (e.g., a Wheatstone bridge comprising the sensor elements) by a processing circuit (e.g., and without limitation thereto, an electronic processor, a microcontroller, a microprocessor, a digital signal processor, and the like),
- mapping, by the processing circuit, the received sensor signals to an output value indicative of the current flowing in the conductor, and
- outputting the output value, e.g., as the current to be measured,

wherein the mapping comprises using, with respect to the predetermined reference point, a multipole expansion of the magnetic field generated by the current, the multipole expansion comprising a predetermined number of predetermined multipole components and respectively associated predetermined multipole coefficients. These coefficients may be stored in a non-volatile memory (e.g., flash) of the sensor device.

The plurality of sensor elements may be mounted on one or more printed circuit boards (PCB's), e.g., on a single PCB.

The location of the reference point may be a predefined position in a cross-sectional area of the electrical conductor.

Some aspects are based on the idea of not only measuring the magnetic field generated by the current flowing through an electrical conductor in a spatial point but determining a strength of a spatial harmonic or a spatial pattern of the magnetic field generated by the current. The spatial harmonic/pattern is the mathematical equivalent of the magnetic multipole expansion. The strength of the spatial harmonic/pattern of the magnetic field generated by the current flowing in the conductor is a property of the conductor shape that does not change over time. Therefore, the method for determining the current in the conductor according to some examples is insensitive to (at least local) variations in the actual sensor locations relative to the conductor. Some examples use the spatial (solid, fixed, unchangeable over time) pattern to become independent of small relative movements between the sensor elements (or the Printed Circuit Board the sensor elements are mounted on) and the conductor. This applies to both direct (DC) and alternating (AC) currents flowing in the conductor. Even in the latter case, where AC currents of different frequencies will create slightly different spatial patterns (e.g., due to skin effect), i.e., the multipole expansion shows a frequency dependency, this frequency dependency is not time dependent in the sense that it will not degrade over time.

Likewise, the method is also robust to interference due to external fields unrelated to the current flow in the conductor such as stray fields, crosstalk etc. These characteristics allow a precise determination of the current in the conductor. Therefore, some examples makes it possible to dispense with magnetic cores and/or shielding (i.e., facilitate core-less and shield-less sensor devices) without sacrificing accuracy, which results in cost savings and an increase in bandwidth since ferromagnetic core materials generally limit the bandwidth to a few 10 kHz, e.g., 200 kHz, 100 kHz, 50 kHz, or even lower, such as 30 kHz, 20 kHz, 10 kHz.

It should be emphasized that the sensor signals together provide the sought strength of the spatial harmonic/pattern of the magnetic multipole expansion.

The method may comprise the addition step of: arranging the sensor elements in a predefined manner relative to the electrical conductor, for example by arranging a printed circuit board (PCB) comprising the sensor elements in a predefined manner relative to the electrical conductor. The sensor elements have a fixed relative position and orientation to each other (because they are mounted on the PCB). After arranging the PCB in the predefined manner to the electrical conductor, each sensor element also has a predefined position and orientation relative to the electrical conductor.

In some embodiments, the method comprises the additional step of providing the conductor.

The method for determining a current flowing in a conductor (e.g., a cable, a busbar, and the like) as set forth above alternatively may be specified in accordance with an aspect comprising the steps of:

- providing a number of magnetic sensor elements (e.g., analog or digital sensor elements such as Hall elements, circular Hall elements, horizontal Hall elements, vertical Hall elements, magneto-resistive (MR) elements, AMR elements, XMR elements, GMR elements, TMR elements, etc.), which are sensitive to a magnetic field generated by the current, at respective sensor locations relative to a predetermined reference point (herein also referred to as the origin of the multipole expansion),
- outputting, by the magnetic sensor elements, sensor signals indicative of a characteristic of the magnetic field, e.g., a field component of the magnetic field oriented in a particular direction, at the respective sensor locations,
- receiving the sensor signals from the magnetic sensor elements or from a circuit (e.g., a Wheatstone bridge comprising the sensor elements) by a processing circuit (e.g., and without limitation thereto, an electronic processor, a microcontroller, a microprocessor, a digital signal processor, and the like),
- mapping, by the processing circuit, the received sensor signals to an output value indicative of the current flowing in the conductor, and
- outputting the output value, e.g., as the current to be measured,

wherein the mapping comprises a position compensation such that the mapped output value is substantially invariant to a change in a relative position between the sensor elements and the conductor.

In general, the sensor elements may be configured to detect a predefined or an arbitrary field component of the magnetic field, i.e., $B_x$, $B_y$, and/or $B_z$ field components with respect to three spatial directions x, y, and z.

Additionally or alternatively, signals from at least some of the sensor elements may be combined (e.g., added, subtracted, linearly combined, etc.) to detect a field gradient of the magnetic field in an arbitrary spatial direction such as x, y, and/or z.

In any case, it should be noted that the sensor elements measuring the same information, i.e., having identical sensor locations and measuring identical spatial field components of the magnetic field, do not contribute to the total number of sensor elements.

On the other hand, in the event the sensor elements measure the magnetic field in different spatial directions, a single package sensor (such as one SMD package, for example) measuring the magnetic field at the same location but in different spatial directions may count as multiple sensor elements. For example, a bidirectional sensor package (also referred to as a "2D magnetic sensor") in one physical sensor location is to be interpreted as two sensor elements.

The method may comprise the addition step of: arranging the sensor elements in a predefined manner relative to the electrical conductor, for example by arranging a printed circuit board (PCB) comprising the sensor elements in a predefined manner relative to the electrical conductor. The sensor elements have a fixed relative position and orientation to each other (because they are mounted on the PCB). After arranging the PCB in the predefined manner to the electrical conductor, each sensor element also has a predefined position and orientation relative to the electrical conductor.

In some embodiments, the method comprises the additional step of providing the conductor.

In some embodiments all or some of the sensor elements may detect the magnetic field oriented in the same spatial direction, i.e., detect a same field component or field gradient of the magnetic field.

In other embodiments at least some or all of the sensor elements may be configured or their signals may be combined (e.g., added, subtracted, linearly combined, etc.) to detect the magnetic field in different spatial directions, i.e., detect different field components or field gradients of the magnetic field. Providing the sensor elements sensitive to different spatial directions delivers more information in order to compensate spatial position variations between the sensor elements and the conductor over lifetime as well as to suppress external field interference.

Preferably, these sensitivity directions span a 90 ° angle.

In an embodiment, some sensor elements are configured for sensing a magnetic field component (typically denoted as Bx) in a first direction (e.g., X), and some sensor elements are configured for sensing a magnetic field component (typically denoted as By) in a second direction (e.g., Y) perpendicular to the first direction (X), and optionally some sensor elements are configured for sensing a magnetic field component (typically denoted as Bz) in a third direction (e.g., Z) perpendicular to the first direction (X) and perpendicular to the second direction (Y).

In still other preferred embodiments, the sensor locations are determined such that a spatial distance between at least two of the sensor elements is larger than a maximum operational spatial position variation of a relative position between the sensor elements and the conductor over lifetime one wishes to compensate. In this way it is guaranteed that the sensor elements measure relevant field variations due to spatial positions variations.

In certain embodiments, the conductor has a rectangular cross section having a length L and a width W, and at least two sensor elements are spaced apart by a distance larger than the smaller of L and W.

In certain embodiments, the conductor has a diameter D or a largest diagonal D, and at least two sensor elements are spaced apart by a distance larger than D.

In yet other advantageous embodiments, the sensor locations are determined to be at positions of high symmetry, e.g., within a symmetry/mirror plane, which provides less signal variations under position variations over lifetime (due to the vanishing gradients there) to be compensated. Alternatively, some of the sensor locations may be chosen to be at symmetry/mirror points w.r.t. a symmetry/mirror plane, as the sum or difference of the corresponding signals will inherently compensate spatial variations to first order, providing a more robust system.

Furthermore, the magnetic sensor elements are configured such that measured signal differences along the same spatial direction must be significantly larger than typical noise amplitudes of the used sensor elements.

For the following description, bold letters represent a vector or a matrix depending on the context.

In general, the magnetic field **B** (herein also referred to synonymously as an induction field) generated by the current in the conductor can be described as a superposition of a number $M_m$ of multipoles $\boldsymbol{m}^\alpha$ in a region of interest, i.e., at the predetermined sensor locations of the sensor elements.

The multipole expansion of the induction field **B** in free space (i.e., $\mu_r \approx 1 = \text{const}$) is

$$B_i(\mathbf{x}) = \sum_{\alpha=1}^{M_m} m_i^\alpha(\mathbf{x}) \cdot c_\alpha,$$

where $x$ denotes a position vector, $M_m$ the predetermined number of multipole components $\boldsymbol{m}^\alpha$, $B_i(\boldsymbol{x})$ the $i$-th vector component of the induction field distribution, $c_\alpha \in R$ the multipole coefficients associated with the respective multipole components, and $m_i^\alpha(\boldsymbol{x})$ the distribution of the $i$-th vector component of the $\alpha$-th multipole. The admissible multipole components fulfill $\sum_{i=1}^{3} \frac{\partial m_i}{\partial x_i} = 0$ to adhere to Maxwell's equation $\nabla \cdot \mathbf{B} = 0$.

The coefficients of $c_\alpha$ may be determined by means of simulations, or by means of measurements.

According to further advantageous embodiments, the multipole coefficients $c_\alpha$ are determined as a solution vector **c** of a linear system of equations **M c = b** given by a system matrix **M** composed of the number of the multipole components evaluated at the sensor locations and by a right-hand side vector **b** formed by the received sensor signals, wherein the linear system of equations is solved by an inverse of the system matrix **M** if the number of the magnetic sensor elements equals the number of the multipole components, by least squares normal equations if the number of the magnetic sensor elements is greater than the number of the multipole components, and by choosing a minimal norm solution if the number of the magnetic sensor elements is less than the number of the multipole components, i.e., by using a pseudo-inverse of the system matrix **M**.

In other words, the multipole coefficients are the elements of a vector **c** that is determined by minimizing the square of the norm $\|\mathbf{M} \mathbf{c} - \mathbf{b}\|$, where the system matrix **M** is composed of the number of multipole components evaluated at the sensor locations and the vector **b** is formed by the received sensor signals, where in case the number of the sensor elements is less than the number of the multipole components said minimum is found with the additional side condition of minimal norm $\|\mathbf{c}\|$ of the solution vector **c**.

In some embodiments, the multipole coefficients $c_\alpha$ are determined during a calibration phase of an electrical assembly comprising the electrical conductor and the magnetic sensor elements during which the sensor signals are received by the processing circuit while a predetermined calibration current is impressed into the conductor. The multipole coefficients may be stored in a non-volatile memory (e.g., flash) mounted on the PCB or embedded in the sensor device.

In still further embodiments, the multipole coefficients are determined purely by calculation based on a geometric relationship of the sensor locations relative to the conductor, e.g., by using finite element (FE) simulations. The purely pre-calculated multipole coefficients may serve as a starting point before the calibration phase during which the multipole coefficients are determined with more precision depending on actual manufacturing tolerances of a current sensor device or a current measuring system, for example.

The magnetic field of the conductor is linear w.r.t. to the current flowing in the conductor. This can be reflected in the multipole expansion by

$$B_i(\mathbf{x}) = \sum_{\alpha=1}^{M_m} m_i^\alpha(\mathbf{x}) \cdot \gamma \, c_\alpha^{cal}$$

where $c_\alpha^{cal}$ denotes the expansion coefficients for the predetermined calibration current $I^{cal}$ that is impressed into the conductor during the calibration phase of the magnetic sensor elements and $\gamma = \dfrac{I^{meas}}{I^{cal}}$ is a linear factor (herein also referred to as a relative current amplitude) that provides the multipole coefficients for the current $I^{meas}$ to be determined in the conductor after the calibration phase, i.e., during an intended measurement phase.

With the given number $N_s$ of the sensor elements at the given sensor locations $d_j$ (which might be partly identical, i.e., $d_m \equiv d_n$ for some $n \neq m$ when different spatial field directions are measured at the same sensor location), the measured signals can be characterized by

$$\mathbf{B}(\mathbf{d_j}) = \sum_{\alpha=1}^{M_m} \mathbf{m}^\alpha(\mathbf{d_j}) \cdot c_\alpha^{cal} \quad \text{for all } j \in \{1, \dots N_s\}, \qquad (eq.\ 1)$$

if the current in the conductor equals $I^{cal}$.

At the calibration phase, the sensor elements are positioned in a predefined manner relative to the electrical conductor (e.g., by arranging a PCB containing the sensor elements in a predefined manner relative to the electrical conductor), and the sensor signals $s_j^{cal}$ for $j = 1, \dots, N_s$ are measured by the sensor elements for the predetermined fixed calibration current $I^{cal}$. To calibrate the sensor elements, eq. 1 becomes

$$s_j^{cal} = \sum_{\alpha=1}^{M_m} \mathbf{m}^\alpha(\mathbf{d_j}) \cdot c_\alpha^{cal}, \qquad (eq.\ 2)$$

which is to be solved for the $c_\alpha$'s.

Preferably the solution is then stored in a non-volatile memory (e.g., flash) of the sensor device, or connected to the processing circuit, from where they can be retrieved.

If the number $N_s$ of the sensor signals is larger than the number $M_m$ of multipole components, this provides a linear least square (LS) fit problem. The system matrix $M_{j\alpha} \equiv \mathbf{m}^\alpha(\mathbf{d}_j)$ is assumed to be known, as the sensor locations $\mathbf{d}_j$ are predefined by the actual design. The solution to this problem is given by the LS normal equations. Using the matrix A defined by $\mathbf{A} \equiv (\mathbf{M}^T\mathbf{M})^{-1}\mathbf{M}^T$, we obtain

$$c_\alpha^{cal} = \sum_{j=1}^{N_s} A_{\alpha j}\, \mathbf{s}_j^{cal} \qquad (\text{eq. } 3)$$

The same formula also applies in the case, when the number of sensor signals is less than the number of unknown multipole coefficients, i.e., $N_s < M_m$. This solution is then characterized by the least norm $\left\| c_\alpha^{cal} \right\| = \min$ within the infinite set of solutions to the underdetermined linear system of equations. The corresponding matrix $A_{\alpha j}$ is the pseudo-invers of matrix $M_{j\alpha}$. It is plausible to assume that this solution is the correct answer from a physical point of view. Still, it is desirable to use as many sensor signals as there are independent multipole components.

According to further advantageous embodiments, the mapping further comprises the step of predicting the sensor signals as predicted sensor signals from a previous output value using a linear combination of the multipole components evaluated at the respective sensor locations and weighted with the respectively associated multipole coefficients, and correcting the output value according to a difference between the predicted sensor signals and the received sensor signals.

The prediction is based on a predetermined measurement model describing the underlying physical system whose current is to be determined. With the given multipole coefficients $c_\alpha^{cal}$, which are known from the calibration phase, for example, the measurement model may be obtained from eq. 1 and 2 to predict the sensor signals for an unknown current $I^{meas} = \gamma \cdot I^{cal}$ as

$$\mathbf{s}_j(\gamma) = \sum_{\alpha=1}^{M_m} \mathbf{m}^\alpha(\mathbf{d}_j) \cdot \gamma\, c_\alpha^{cal}.$$

Experiments have shown that a Kalman filter approach provides a well-suited scheme to perform the signal processing for determining the current in the conductor. The Kalman filter depends on a state vector (herein also referred to as the output value) comprising the state variables fully defining the state of the underlying physical system, the setup of a dynamic model describing the temporal variation of the state variables forming the state vector, and a measurement model connecting the (raw) sensor signals with the system state.

In the above-described case the only state variable is $\gamma$ which fully defines the physical system to derive all relevant physical properties.

In still further embodiments the mapping additionally comprises the step of determining an actual translational and/or an actual rotational displacement of the sensor locations relative to the sensor locations at the calibration phase.

If, in addition to the current to be determined, there is an unknown translation t between the actual sensor locations and the sensor locations in the calibration phase, the measurement model given above can be extended to account for the translational displacements as

$$\mathbf{s}_j(\gamma, \mathbf{t}) = \sum_{\alpha=1}^{M_m} \mathbf{m}^\alpha(\mathbf{d}_j + \mathbf{t}) \cdot \gamma\, c_\alpha^{cal}. \qquad (\text{eq. } 4)$$

This is so, because the multipole coefficients express the magnetic field of the conductor, which does not change, except for the linear scaling factor $\gamma$ and possibly for the translation vector t. Eq. 4 provides the basis for a robust determination of the current in the conductor under (small/local) spatial distortions.

If the relative position of the sensor elements and the conductor also includes rotational displacements, the measurement model may be generalized to

$$s_j(\gamma, \mathbf{t}, \theta) = \sum_{\alpha=1}^{M_m} \mathbf{m}^\alpha\big(\mathbf{R}(\theta)\, \mathbf{d}_j + \mathbf{t}\big) \cdot \gamma\, c_\alpha^{cal},$$

where $\mathbf{R}(\theta)$ corresponds to a rotation matrix along a longitudinal axis of the conductor by an angle $\theta$, which asks for including $\theta$ as an additional state variable.

The magnetic sensor elements may be mounted on a common rigid body (e.g., a printed circuit board, PCB) so that the translational and/or rotational movements of the sensor elements relative to the conductor are substantially identical for all sensor elements.

It is to be noted that an updating rate of the actual displacements of the sensor locations and an updating rate for determining the current in the conductor may be different as will be described further below. Alternatively, the updating rates may be identical.

As an example, the most basic state vector in the above-described case of translational displacements of the sensor elements relative to the conductor is given by $(\gamma, t_x, t_y)^T$. If these state variables are known, the system is fully defined and one can derive all relevant properties of the underlying physical system. Further below, some variations of this system state are introduced, which leads to a more performant approach.

The simplest dynamic model for the state vector in this case assumes that all state variables are stationary but subject to white noise

$$\begin{pmatrix} \dot{\gamma} \\ \dot{t}_x \\ \dot{t}_y \end{pmatrix} = \begin{pmatrix} 0 \\ 0 \\ 0 \end{pmatrix} + \begin{pmatrix} \eta_\gamma \\ \eta_{t_x} \\ \eta_{t_y} \end{pmatrix}, \qquad (eq.\ 5)$$

where the vector $\eta = (\eta_\gamma, \eta_{tx}, \eta_{ty})^T$ denotes random variables for white noise with vanishing mean and its covariance given by

$$cov(\eta) = \begin{pmatrix} \sigma_\gamma^2 & 0 & 0 \\ 0 & \sigma_{t_x}^2 & 0 \\ 0 & 0 & \sigma_{t_y}^2 \end{pmatrix} \qquad (eq.\ 6)$$

The so-called process variances $\sigma_\gamma$ etc. correspond to unmodelled, a priori unknown temporal changes of the state variables.

The measurement model is given by eq. 4, i.e.,

$$s_j(\gamma, \mathbf{t}) = \sum_{\alpha=1}^{M_m} \mathbf{m}^\alpha\big(\mathbf{d}_j + \mathbf{t}\big) \cdot \gamma\, c_\alpha^{cal} + v_j, \qquad (eq.\ 7)$$

where a random variable for white noise $v_j$ for the sensor element $j$ was added to account for measurement noise (again characterized by zero mean and a variance $\sigma_{s_j}$). This model is in general non-linear as the multipoles $\mathbf{m}^\alpha(\mathbf{x})$ might non-linearly depend on the translation vector $\mathbf{t}$ (cf. multipole component $\mathbf{m}^5$ given further below) and furthermore, they are multiplied by $\gamma$. This approach may correspond to an extended Kalman filter.

To this end, an estimator-corrector-scheme may be provided to update the state vector upon new evidence, i.e., newly measured and received sensor signals $s_j$. The covariance $cov(\eta)$ allows for a correct attribution of signal changes to the most probable cause in cases where this is not deterministically given due to measurement noise. If the system suffers only slow spatial position changes (e.g., over lifetime), a change in the conductor current (i.e., state variable $\gamma$) is a much more probable cause of (raw) sensor signal variations, compared to changes in the translation t.

On the other hand, a system subject to vibration might suffer from positional changes on a similar or even faster timescale compared to the current variable. This case may then be characterized by a much larger value of the process variance for, e.g., $\sigma_{t_x}$ etc.

Therefore, different updating rates for the translational and/or rotational displacements and for the determining of the current in the conductor may be appropriate and will be considered in the various embodiments.

According to further advantageous embodiments, the reference point is preferably determined to be in a symmetry plane of the conductor, (or actually of a small portion of the conductor). Such a symmetry plane may be a mirror plane such as a plane containing the longitudinal axis of a long straight conductor. The conductor may be a relatively long straight busbar having a rectangular cross section, for example, but even if the busbar is short or is curved, the reference point is preferably chosen relative to the shape of the cross section in a plane perpendicular to the direction of local current flow.

Alternatively or additionally, the reference point may be determined to be on a line of inversion symmetry of the conductor or at an inversion point thereof.

In both cases mentioned it is possible to reduce the number of multipole components that must be considered in the multipole expansion to determine the current in the conductor. This is because the magnetic field generated by the current cannot contribute to a particular spatial direction in this symmetry plane or point of symmetry, since the corresponding associated multipole coefficient of this multipole component becomes zero. Therefore, choosing the reference point to be a point or a plane of high symmetry advantageously reduces the computational effort for the processing circuit, which allows the use of less powerful hardware, for example.

Moreover, by using the symmetry of the conductor, the spatial dimensions to be considered for the multipole expansion can also be reduced. For example, it may be sufficient to consider the multipole expansion for only two spatial dimensions (2D) instead of three (3D), since the field of interest is rendered to be 2D by the symmetry of the conductor (e.g., a long straight conductor such as a busbar). This further reduces the computational effort for the processing circuit.

Additionally or alternatively, the reference point or origin of the multipole expansion may be chosen to be a short distance from the sensor locations of the sensor elements. Placing the sensor elements close to the reference point will lead to a multipole expansion that converges fast. Thus, the contribution of the higher order multipole components rapidly vanishes and need not be considered to obtain the accurate and robust results.

It has been found that accurate and robust results can be obtained in some embodiments in which the multipole expansion comprises up to a second order maximum, i.e., a $0^{th}$, $1^{st}$, and $2^{nd}$ order in the spatial coordinates.

As an example, in a 2D situation the number of multipole components $M_m = 6$ up to the $2^{nd}$ order are (given as vectors of the induction field in a plane perpendicular to the longitudinal axis of the conductor, e.g., a busbar):

$$\mathbf{m}^1 = \begin{pmatrix} 1 \\ 0 \end{pmatrix}, \ \mathbf{m}^2 = \begin{pmatrix} 0 \\ 1 \end{pmatrix}, \ \mathbf{m}^3 = \begin{pmatrix} x_2 \\ x_1 \end{pmatrix}, \ \mathbf{m}^4 = \begin{pmatrix} x_1 \\ -x_2 \end{pmatrix}, \ \mathbf{m}^5 = \begin{pmatrix} 3x_1^2 - 3x_2^2 \\ -6x_1 x_2 \end{pmatrix},$$

$$\mathbf{m}^6 = \begin{pmatrix} 6x_1 x_2 \\ 3x_1^2 - 3x_2^2 \end{pmatrix},$$

where $x_1$ represents a first spatial direction in the plane (herein also referred to as the x-direction) and $x_2$ represents a second spatial direction in the plane (herein also referred to as the y-direction). The third spatial direction, i.e., $x_3$ or the z-direction, need not be considered if the conductor extends straight along its longitudinal axis and has a uniform cross-section.

Aside of the choice of the number of expansion orders to be considered, the origin (i.e., the reference point) of the multipole expansion can also be chosen advantageously. For example, this point can be chosen to be at the geometric center (i.e., the centroid) of the sensor elements. This ensures a short distance of the reference point from the sensor elements. Then, the values entering the coordinate variables (i.e., x, y, z or x1, x2, and x3, respectively) will be small, i.e., the relative contributions will become quickly smaller for higher order multipole components.

The stated number of multipole components above corresponds to a situation, where the magnetic field at the origin of the multipole expansion does not exhibit any symmetries. If a symmetry is present, e.g., a mirror plane due to the symmetry of the conductor geometry, the number of multipole components will be reduced. As an example, if the conductor has a flat and elongated geometry, there is no field component of the magnetic field in the y-direction in the middle plane (i.e., the symmetry plane) along the longitudinal axis of the conductor. This corresponds to the vanishing of the multipole

coefficient $c_2$ of $\mathbf{m}^2 = \begin{pmatrix} 0 \\ 1 \end{pmatrix}$ if the origin is chosen in the middle plane.

In some embodiments, the current to be determined is a direct current (DC).

In other embodiments the current to be determined is an alternating current (AC) and the mapping further comprises the step of determining an instantaneous phase of the alternating current.

In this case the dynamic model for the current variable $\gamma$ may be extended to describe AC currents, where this state variable is no longer constant but corresponds to harmonic variations. Using the parametrization for the AC current to be determined given by $I^{meas}(t) = \gamma \sin(\phi) \cdot I^{cal}$, the dynamic prediction model would be improved to (cf. eq. 5)

$$\begin{pmatrix} \dot{\gamma} \\ \dot{\phi} \\ \dot{\omega} \\ \dot{t}_x \\ \dot{t}_y \end{pmatrix} = \begin{pmatrix} 0 \\ \omega \\ 0 \\ 0 \\ 0 \end{pmatrix} + \begin{pmatrix} \eta_\gamma \\ \eta_\phi \\ \eta_\omega \\ \eta_{t_x} \\ \eta_{t_y} \end{pmatrix},$$

where $\omega$ denotes the angular frequency of the determined AC current and $\phi$ its instantaneous phase.

According to yet further embodiments, more than one conductor is provided and determining the current comprises determining individual currents respectively flowing in each of the conductors, wherein for each of the conductors a separate multipole expansion is used.

The determination of 3-phase alternating currents can also be performed using the principles disclosed herein. For each of the 3 phases, a set of sensor signals $s_j^X$ with $X \in U, V, W$ is measured. For the B-field generated by the three conductors, a separate multipole expansion is performed. Instead of the scalar variable $\gamma$, the 3-phase relative current amplitude vector $\gamma = (\gamma_U, \gamma_V, \gamma_W)^T$ is introduced describing the relative current amplitudes of the three phases.

If the phases interfere with each other - i.e., the system exhibits crosstalk - the corresponding measurement model has to include the effect of, e.g., phase $U$ on phase $V$. As the different phases are separated by much larger distances compared to the sensor locations of the sensor elements per phase, this crosstalk will only include the lowest order multipoles (e.g., up to linear in the spatial coordinates) to reduce the workload in signal processing.

The dynamic model for 3-phase current can incorporate the specific correlations inherent in this case. In this way, the measurement accuracy will be improved as the measured signals are fully leveraged against the a priori knowledge due to the 3-phase characteristics.

In certain embodiments, a single PCB is mounted in a predefined position relative to three electrical conductors (e.g., three busbars), and the single PCB contains two groups of sensor elements, each group of sensor elements being located in a space between two electrical conductors (e.g., as illustrated in FIG. 14). Each group may comprise for example at least two or at least three magnetic sensor elements. In this case, only a single translation and rotation vector is applicable for all of the magnetic sensors.

In a variant, two PCBs are mounted in a predefined position relative to three electrical conductors (e.g., three busbars), and each of the PCB contains a group of sensor elements, each group of sensor elements being located in a space between two electrical conductors. Each group may comprise for example at least two or at least three magnetic sensor elements. In this case, a first translation and rotation vector is applicable for the magnetic sensors of the first PCB, and a second translation and rotation vector is applicable for the magnetic sensors of the second PCB.

Depending on the mechanical structure of the conductor arrangement, the number of mechanical degrees of freedom (i.e., translation vectors, rotation angles) may be increased to address relative position changes of each conductor separately. This is certainly necessary, if they do not behave as a rigid body ensemble.

All sensor signals can be determined uniformly in time (i.e., simultaneously) to provide concurrent state variable updates. This leads to complex matrix operations taking into account all cross-correlations. However, it is also possible to do the measurements non-uniformly or non-simultaneously, i.e., sensor element after sensor element, and perform the state variable updates step by step accordingly.

Especially for 3-phase AC currents, a mixed approach seems particularly advantageous: receiving one of the sensor signals of the individual sensor elements of each phase concurrently and performing an update of the 3-phase relative current amplitudes. The remaining state variables describing the spatial positions, however, are only updated once all sensor signals are received anew. In this way, the computational effort will be minimized and at the same time the fluctuations of the relative current amplitudes be minimized.

According to further advantageous embodiments, signals from various sensor elements may be combined to correspond to a gradient of the magnetic field at the respective sensor locations with respect to a predetermined spatial direction. From the gradient, even more accurate information about the location changes (i.e., translation and/or rotation) of the actual sensor locations can be derived.

In yet further embodiments, the number of magnetic sensor elements is equal to or greater than the number of multipole components.

Generally, the minimal number of sensor signals $N_s$ necessary for the determination of the current in the conductor corresponds to the maximum of the number of system degrees of freedom given by the number of current phases $N_p$ and the mechanical rigid body motions $N_r$, i.e.,

$$N_s \geq N_p + N_r$$

For best accuracy, the number of the involved multipole components $M_m$ should also be considered. While it is possible to do the calibration for $M_m > N_s$ using the pseudo-invers approach as described herein, the calibration accuracy will be improved if $M_m \leq N_s$, i.e.,

$$N_s \geq \max\left(M_m, N_p + N_r\right)$$

In the following, some examples are given.

Example 1

For a long straight conductor (e.g., a busbar or cable) the B-field components to be considered are only those which are in a plane perpendicular to the conductor. With the number of up to first order multipole components $M_m = 4$ (i.e., $\boldsymbol{m}^\alpha(\boldsymbol{x})$, $\alpha = 1, \ldots, 4$), a single current phase ($N_p = 1$) and two translational degrees of freedom for the relative displacement of the sensor locations of the sensor elements relative to the conductor ($N_r = 2$), we find:

$$N_s \geq 3$$

Example 2

By placing the origin (i.e., the reference point) of the multipole expansion into a symmetry plane of the conductor, e.g., for a strip-like busbar, the origin may be determined to be in the middle plane of the busbar cross section, either $\boldsymbol{m}^1(\boldsymbol{x})$ or $\boldsymbol{m}^2(\boldsymbol{x})$ do not contribute to the magnetic field due to symmetry. Then $M_m = 3$, $N_p = 1$ and $N_r = 2$, and

$$N_s \geq 3,$$

where this number of sensor signals allows for a full characterization of the multipole coefficients at calibration time.

Example 3

For a system according to example 1, but with an additional rotational degree of freedom to the two translational ones, i.e., $N_r = 3$,

$$N_s \geq 4$$

However, in this case the origin of the multipole expansion is not determined to be in a symmetry plane of the conductor, as then the necessary information cannot be provided by the sensor elements in the first place.

Example 4

Again, choosing an adequate origin of the multipole expansion will lower the number of excited multipole components to, e.g., $M_m = 4$, allowing a system with $N_r = 3$ rigid body degrees of freedom (here including rotations) and a single current phase $N_p = 1$ according to

$$N_s \geq 4$$

According to a further aspect, a current sensor device for determining a current flowing in a conductor (e.g., a cable, a busbar, and the like), comprises:

- a number of magnetic sensor elements (e.g., analog or digital sensor elements such as Hall elements) sensitive to a magnetic field generated by the current, wherein each of the magnetic sensor elements is arranged at respective sensor locations relative to a predetermined reference point (herein also referred to as the origin of the multipole expansion) and configured to respectively output sensor signals indicative of a field component of the magnetic field at the respective sensor locations, and
- a processing circuit (e.g., and without limitation thereto, an electronic processor, a microcontroller, a microprocessor, a digital signal processor, and the like) configured to receive the sensor signals from the magnetic sensor elements,

wherein the processing circuit is configured to map the received sensor signals to an output value indicative of the current flowing in the conductor, and to output the output value, wherein the mapping comprises using, with respect to the predetermined reference point, a multipole expansion of the magnetic field generated by the current, the multipole expansion comprising a predetermined number of predetermined multipole components and respectively associated predetermined multipole coefficients.

It is to be noted that with respect to the effects and advantages of the features regarding the sensor device disclosed herein, reference is made in its entirety to the corresponding analogous features of the method as well as its effects and advantages disclosed herein. Therefore, features of the method shall be regarded also as features applicable for the definition of embodiments of the sensor device, and vice versa, unless explicitly stated otherwise. Hence, for the purpose of conciseness of this specification and an improved understanding of the principles a duplication of explanations of such analogous features, their effects and advantages may be omitted without any such omissions to be construed as limitations.

The sensor device for determining a current flowing in a conductor (e.g., a cable, a busbar, and the like) as set forth above may be alternatively specified in accordance with an aspect comprising:

- a number of magnetic sensor elements (e.g., analog or digital sensor elements such as Hall elements, circular Hall elements, horizontal Hall elements, vertical Hall elements, magneto-resistive (MR) elements, AMR elements, XMR elements, GMR elements, TMR elements, etc.) sensitive to a magnetic field generated by the current, wherein each of the magnetic sensor elements is arranged at respective sensor locations relative to a predetermined reference point (herein also referred to as the origin of the multipole expansion) and configured to respectively output sensor signals indicative of a characteristic (e.g., a field component) of the magnetic field at the respective sensor locations, and
- a processing circuit (e.g., and without limitation thereto, an electronic processor, a microcontroller, a microprocessor, a digital signal processor, and the like) configured to receive the sensor signals from the magnetic sensor elements,

wherein the processing circuit is configured to map the received sensor signals to an output value indicative of the current flowing in the conductor, and to output the output value, wherein the mapping comprises a position compensation such that the mapped output value is invariant with respect to a change in a relative position between the magnetic sensor elements and the conductor.

In advantageous embodiments, the magnetic sensor elements are mounted on a common rigid body. In this way, translational and/or rotational movements (i.e., location displacements) of the sensor elements relative to the conductor are substantially identical for all sensor elements which reduces the computational effort for the processing circuit.

In some embodiments, a first subset of the sensor elements is mounted on a first rigid body, e.g., a first PCB, and a second subset of the sensor elements are mounted on a second rigid body.

In some embodiments, signals from one or more of the magnetic sensor elements are combined (e.g., added, subtracted, linearly combined, etc.) to respectively output a gradient of the magnetic field as the field component at the respective sensor locations with respect to a predetermined spatial direction.

In still further embodiments, the number of magnetic sensor elements is equal to or greater than the number of multipole components.

According to yet a further aspect, a current measuring system comprises at least one conductor and a current sensor device according to any of the herein disclosed embodiments for determining a current flowing in the at least one conductor.

Again, it is to be noted that with respect to the effects and advantages of the features regarding the measuring system, reference is made in its entirety to the corresponding analogous features of the method and the sensor device disclosed herein. Therefore, features of the method and sensor device shall be regarded also as features applicable for the definition of embodiments of the measuring system, and vice versa, unless explicitly stated otherwise. Hence, for the purpose of conciseness of this specification and an improved understanding of the principles a duplication of explanations of such analogous features, their effects and advantages may be omitted without any such omissions to be construed as limitations.

In some embodiments, the magnetic sensor elements are arranged in a plane oriented perpendicular or parallel to a longitudinal axis of the conductor.

In further embodiments, the reference point (herein also referred to as the origin of the multipole expansion) is determined to be in a plane including a longitudinal axis of the conductor.

In yet further advantageous embodiments, the magnetic sensor elements are arranged along a virtual sensing line around the conductor that includes an angular range between 20 to 45 degrees, more preferably between 20 to 90 degrees, and yet more preferably up to 180 degrees.

In some embodiments, the magnetic sensor elements are arranged on a PCB oriented perpendicular to direction of current flowing through the electrical conductor, and an angle formed between a first leg defined by one of the sensor locations and a geometric center of a cross-section, and a second leg defined by another sensor location and said geometric center, is an angle of at least 20°, or at least 30°, or at least 45°, or at least 60°, or at least 90°, or at least 120°, or at least 150°.

In still other embodiments, the magnetic sensor elements are arranged along a virtual sensing line around the conductor that spans an angular range that is greater than 180 degrees.

In yet other advantageous embodiments, the current measuring system comprises more than one conductor, e.g., three conductors, and determining the current comprises determining individual currents respectively flowing in each of the conductors, wherein for each of the conductors a separate multipole expansion is used.

Further advantageous embodiments are defined in the drawings and the description below.

## Brief description of the drawings

These and other features and advantages will be apparent from the following description of non-limiting embodiments which will be elucidated below with reference to the drawings.

The drawings are only schematic, i.e., the size of some of the elements may be exaggerated and not drawn to scale for illustrative purposes. The absolute and relative dimensions do not necessarily correspond to actual reductions to practice of various embodiments and examples.

In the drawing, schematically:

Fig. 1    shows a cross-sectional view of a conductor carrying a current to be determined according to an example embodiment.

Fig. 2    shows a perspective view of an example embodiment of a sensor device and a current measuring system.

Fig. 3    shows a perspective view of another example embodiment of a current measuring system.

Fig. 4    shows a cross-sectional view of yet another example embodiment of a current measuring system.

Fig. 5    shows a functional diagram of an example embodiment of a sensor device.

In the various figures, equivalent elements with respect to their function are usually provided with the same reference numerals/signs so that these elements are usually described only once.

## Detailed description of illustrative embodiments

When in the present document reference is made to "conductor", an electrical conductor is meant.

When in the present document reference is made to "a magnetic field gradient oriented in a certain direction", what is meant is a magnetic field gradient of a magnetic field component oriented in the specified direction along a non-specified direction, or a magnetic field gradient of a magnetic field component oriented in a non-specified direction along the specified direction.

When in the present document reference is made to "symmetry plane of the conductor", what reference is made to a symmetry plane of a cross-section of the conductor in a plane perpendicular to the direction of current flow, unless it is clear from the context that something else is meant.

Various embodiments will now be described by means of the Figures.

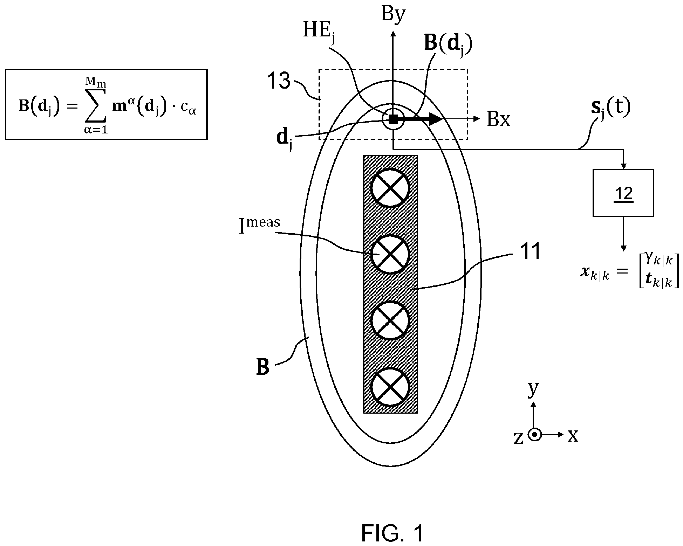

Fig. 1 schematically shows a cross-sectional view of a conductor 11 (e.g., a long flat busbar) carrying a current $I^{meas}$ to be determined according to an example embodiment of a method. The method according to the depicted embodiment comprises the steps of:

- providing a number $N_s$ of magnetic sensor elements $HE_j$ (only one of which is shown in Fig. 1), which are sensitive to a magnetic field B generated by the current $I^{meas}$, at respective sensor locations $\mathbf{d}_j$ relative to a predetermined reference point (not shown),
- outputting, by the magnetic sensor elements $HE_j$, sensor signals $\mathbf{s}_j$ indicative of a field component, e.g., $B_x$ and/or $B_y$, and/or $B_z$, of the magnetic field B at the respective sensor locations $\mathbf{d}_j$,
- receiving the sensor signals $\mathbf{s}_j$ from the magnetic sensor elements $HE_j$ by a processing circuit 12,
- mapping, by the processing circuit 12 (e.g., an electronic processor, a microcontroller, a microprocessor, a digital signal processor, and the like), the received sensor signals $\mathbf{s}_j$ to an output value $\mathbf{x}_{k|k}$ indicative of the current $I^{meas}$ flowing in the conductor 11, and
- outputting the output value $\mathbf{x}_{k|k}$,

wherein the mapping comprises using, with respect to the predetermined reference point, a multipole expansion of the magnetic field **B** generated by the current $I^{meas}$, the multipole expansion comprising a predetermined number $M_m$ of predetermined multipole components $\mathbf{m}^\alpha$ and respectively associated predetermined multipole coefficients $c_\alpha$.

In some embodiments, the method additionally comprises the additional step of providing the conductor 11.

As expressed by the equation in Fig. 1, the magnetic field **B** is a superposition of the $M_m$ multipoles $\mathbf{m}^\alpha$ in a region of interest 13, i.e., where the sensor elements $HE_j$ are arranged and distributed. The multipole coefficients $c_\alpha$ are determined during a calibration phase of the magnetic sensor elements $HE_j$, during which the sensor signals $\mathbf{s}_j$ are received while a predetermined calibration current $I^{cal}$ is impressed into the conductor 11.

The sensor elements $HE_j$ may be configured to detect an arbitrary field component, i.e., $B_x$, $B_y$ or $B_z$ (where the latter is perpendicular to the drawing plane of Fig. 1), of the magnetic field **B**. Actually, any two spatial field components not directing into same direction may be chosen as the field component to be detected. It may not necessarily be along the coordinate system x, y, z depicted in the figures, not even necessarily perpendicular to each other.

Additionally, or alternatively, signals from at least some of the sensor elements $HE_j$ may be combined (e.g., added, subtracted, linearly combined, etc.) to detect a field gradient of the magnetic field **B** in an arbitrary spatial direction x, y, or z (where the latter is perpendicular to the drawing plane in Fig. 1).

In Fig. 1 the output value is shown as an output vector $\mathbf{x}_{k|k}$ containing a relative current amplitude $\gamma$ of the current $I^{meas}$ to be determined and a translation vector **t** representing a translational displacement between the actual sensor locations $\mathbf{d}j$ and the sensor locations during the calibration phase. In the present case, the current $I^{meas}$ to be determined is a direct current, however, without necessarily being restricted thereto.

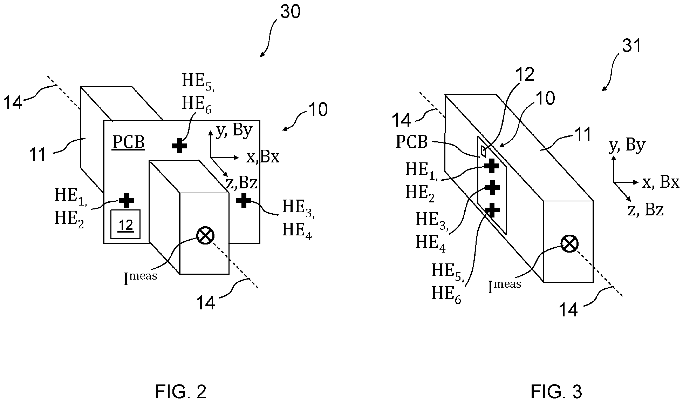

Fig. 2 schematically shows a perspective view of an example embodiment of a sensor device 10 and a current measuring system 30 for determining the current $I^{meas}$ flowing in the conductor 11. The present current sensor device 10 comprises magnetic sensor elements $HE_1$, $HE_2$, $HE_3$, $HE_4$, $HE_5$, and $HE_6$ sensitive to the magnetic field B (cf. Fig. 1) generated by the current $I^{meas}$. The number of sensor elements $HE_1$, $HE_2$, $HE_3$, $HE_4$, $HE_5$, and $HE_6$ in this example is six. However, it is to be understood that the number shown in Fig. 2 is only one example and that more or less sensor elements $HE_j$ may be employed in the sensor device.

In the example sensor device 10 shown in Fig. 2, in each case, two sensor elements, i.e., $HE_1$ and $HE_2$, $HE_3$ und $HE_4$, $HE_5$ und $HE_6$, are arranged essentially at the same location $\mathbf{d}_j$, but they detect the magnetic field **B** in two different spatial directions, here, for example, in the x and y directions, respectively, however without being necessarily limited to the x and y directions only. It is also possible to detect the magnetic field **B** in the z direction, either as an alternative to the x or y direction or in addition to the x and y direction. The respective pairs of sensor elements may be packaged in a single-package sensor component such as one SMD package, for example.

The sensor device 10 further comprises the processing circuit 12, configured to receive the sensor signals $\mathbf{s}_j$ from the magnetic sensor elements $HE_1$-$HE_6$. In the present sensor device 10, the processing circuit 12 and the sensor elements $HE_1$-$HE_6$ are mounted on a common rigid body, e.g., a common printed circuit board (PCB), however, without necessarily being limited thereto. The processing circuit 12 and the sensor elements $HE_1$-$HE_6$ all may be mounted on separate bodies (e.g., PCBs), or only the processing circuit 12 may be mounted separately from the sensor elements $HE_1$-$HE_6$, wherein the sensor elements $HE_1$-$HE_6$ are mounted together on a common rigid body (e.g., a PCB).

While not shown, the PCB may further comprise a non-volatile memory (e.g., flash). The non-volatile memory may be embedded in the sensor device, or in the processing circuit, or may be a discrete component mounted on the PCB but communicatively connected to the processing circuit 12.

In Fig. 2 it is shown that in the present case the sensor elements $HE_1$-$HE_6$ are located in a plane perpendicular to a longitudinal axis 14 of the conductor 11, which corresponds to a cross-sectional plane of the conductor 11.

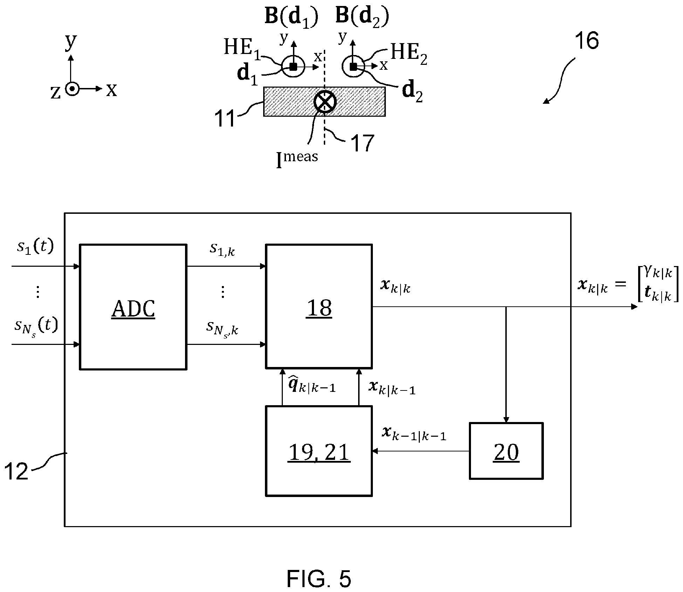

The reference point (not shown), i.e., the origin of the multipole expansion, may be determined to be in a plane including the longitudinal axis 14 of the conductor 11 (cf. Fig. 5), however, without necessarily being limited thereto. Generally, the reference point can be chosen to be at any spatial location.

Fig. 3 schematically shows a perspective view of a further example embodiment of a current measuring system 31 using a sensor device 10' similar to that of Fig. 2. The main difference between the measuring device 31 shown in Fig. 3 and the measuring device 30 shown in Fig. 2 is the orientation of the PCB, and the locations and orientations of the sensor elements $HE_1$-$HE_6$. As seen in Fig. 3, the sensor elements $HE_1$-$HE_6$ are arranged in a plane parallel to the longitudinal axis 14 of the conductor 11. As in the example of the current measuring system 30 depicted in Fig. 2, in the present current measuring system 31 the pairs of the two sensor elements, i.e., $HE_1$ and $HE_2$, $HE_3$ und $HE_4$, $HE_5$ und $HE_6$, detect the magnetic field **B** in two different spatial directions, for example, in the x and y directions. Again, it is also possible to detect the magnetic field **B** in the z direction, either as an alternative to the x or y direction or in addition to the x and y direction. The respective pairs of sensor elements may be packaged in a single-package sensor component such as one SMD package, for example. Each SMD package may also be referred to as a 2D magnetic pixel.

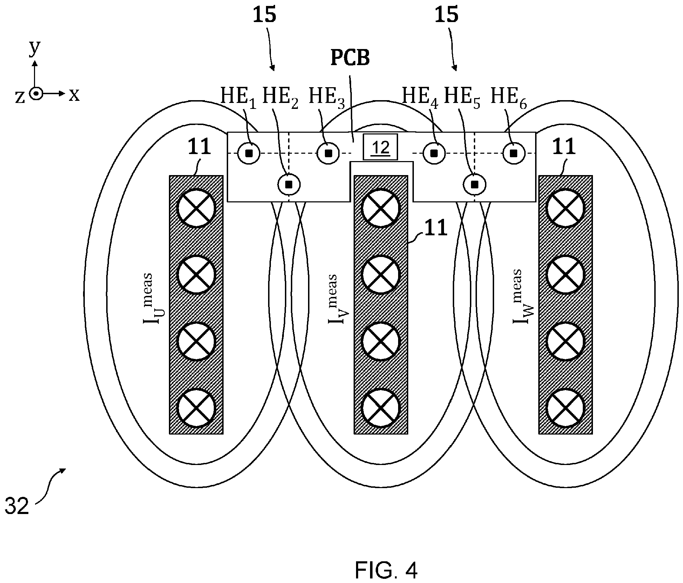

Fig. 4 schematically shows a cross-sectional view of yet another example embodiment of a current measuring system 32 using a sensor device 15 for determining currents $I_U^{meas}$, $I_V^{meas}$, and $I_W^{meas}$ flowing in three conductors 11. In the present case the currents $I_U^{meas}$, $I_V^{meas}$, and $I_W^{meas}$ are 3-phase alternating currents (AC). For each of the conductors 11 a separate individual multipole expansion is used.

In the example case shown in Fig. 4, the sensor device 15 comprises three sensor elements $HE_1$, $HE_2$, $HE_3$, arranged between the leftmost and the middle conductors 11, and $HE_4$, $HE_5$, $HE_6$ arranged between the middle and rightmost conductors 11. The sensor elements $HE_1$, $HE_2$, $HE_3$ mainly see the superimposed magnetic fields generated by $I_U^{meas}$ and $I_V^{meas}$, whereas sensor elements $HE_4$, $HE_5$, $HE_6$ mainly see the superimposed magnetic fields generated by $I_V^{meas}$ and $I_W^{meas}$. In order to determine the current $I_V^{meas}$, all the signals $HE_1$ to $HE_6$ will be used for the calculation of the output value as the sensor elements see the magnetic fields of $I_U^{meas} + I_V^{meas}$ and/or $I_V^{meas} + I_W^{meas}$.

The sensor elements $HE_1$, $HE_2$, $HE_3$, $HE_4$, $HE_5$, and $HE_6$ and the processing circuit 12 are located in a plane perpendicular to the longitudinal axis of the electrical conductors 11, wherein the longitudinal axis extends parallel to the z-direction in the embodiment shown in Fig. 4. Each of the sensor elements $HE_1$-$HE_6$ may be configured to detect the magnetic field **B** in one or more different spatial directions, for example, in the x, y and/or z directions.

Fig. 5 schematically shows a functional diagram of an example embodiment of a sensor device 16. The sensor device 16 for determining a current $I^{meas}$ flowing in a conductor 11 comprises a number $N_s$ of magnetic sensor elements $HE_j$ ($HE_1$ and $HE_2$ of which are shown in Fig. 5, more may be present but are not shown) sensitive to a magnetic field **B** generated by the current $I^{meas}$, wherein each of the magnetic sensor elements, including $HE_1$ and $HE_2$, is arranged at respective sensor locations $\mathbf{d}_j$, e.g., $\mathbf{d}_1$ and $\mathbf{d}_2$, relative to a predetermined reference point (not shown, but in the present case chosen to be in a mirror plane 17 containing the longitudinal axis of the conductor 11) and configured to respectively output sensor signals $s_j(t)$, i.e., $s_1(t)... s_r(t)$ indicative of a field component, e.g., $B_x$ and/or $B_y$, and/or $B_z$ of the magnetic field **B** at the respective sensor locations $\mathbf{d}_j$. Actually, any two spatial field components not directing into same direction may be chosen as the field component to be detected. It may not necessarily be along the coordinate system x, y, z depicted in the figures, not even necessarily perpendicular to each other. The sensor device 16 further comprises a processing circuit 12 configured to receive the sensor signals $s_j(t)$ from the magnetic sensor elements $HE_j$.

As shown in Fig. 5, the processing circuit 12 is configured to map the received sensor signals $s_j(t)$ to an output value $\mathbf{x}_{k|k}$ indicative of the current $I^{meas}$ flowing in the conductor 11, and to output the output value $\mathbf{x}_{k|k}$. The mapping comprises using, with respect to the predetermined reference point, a multipole expansion of the magnetic field **B** generated by the current $I^{meas}$, the multipole expansion comprising a predetermined number $M_m$ of predetermined multipole components $\mathbf{m}^\alpha$ and respectively associated predetermined multipole coefficients $c_\alpha$.

The sensor device 16 uses a Kalman filter approach to generate the output value $\mathbf{x}_{k|k}$ from the (raw) sensor signals $s_j(t)$ as will be explained in the following.

The sensor device 16 comprises a system state corrector 18 configured to determine an actual output value, i.e., a system state, $\mathbf{x}_{k|k}$, of the physical system at a given state update cycle $k$. The state update cycle $k$ corresponds to a time instant $t_k$, where $t_k = kT$ with $T$ being the sampling period. As illustrated in Fig. 5, in the present example the system state vector $\mathbf{x}_{k|k}$ comprises a relative current amplitude $\gamma$ and a translation vector $\mathbf{t}$. Other information may be included in the system state vector $\mathbf{x}_{k|k}$, e.g., an angular frequency $\omega$ and its instantaneous phase $\phi$ in case of determining an AC current as described above.

Further, the sensor device 16 illustrated in Fig. 5 also comprises a system state predictor 19 configured to determine a predicted system state $\mathbf{x}_{k|k-1}$ of the physical system at a given prediction cycle $k$ from a previous system state $\mathbf{x}_{k-1|k-1}$ at a previous state update cycle $k$ - 1. As shown in Fig. 5, the previous system state $\mathbf{x}_{k-1|k-1}$ from a previous state update cycle $k$ - 1 is provided by a delay unit 20. In a simple implementation, this delay unit may be a memory unit (e.g., RAM, Register of $\mu$P or $\mu$C and the like) storing at least one system state $\mathbf{x}_{k|k}$ after being output by the system state corrector 18 so that it can be used in a subsequent state update cycle as the previous system state $\mathbf{x}_{k-1|k-1}$.

Further, the sensor device 16 comprises a sensor signal predictor 21 configured to determine predicted sensor signals $\hat{\mathbf{q}}_{k|k-1}$ at the given prediction cycle $k$ from the predicted system state $\mathbf{x}_{k|k-1}$ using a measurement model of the physical system such as the model described in eq. 7, for example.

Further, the system state corrector 18 of the sensor device 16 in Fig. 5 is configured to determine the actual system state $\mathbf{x}_{k|k}$ at the given state update cycle $k$ by applying a Kalman filter operation to the predicted system state $\mathbf{x}_{k|k-1}$ according to a difference between the received sensor signals $s_{1,k}...s_{N_s,k}$ acquired from the sensor signals $s_j(t)$ at the given prediction cycle $k$ and the corresponding predicted sensor signals $\hat{\mathbf{q}}_{k|k-1}$ for each of the received sensor signals $s_{j,k}$.

In the present example of the sensor device 16 in Fig. 5, the acquired sensor signals $s_{j,k}$ always comprise sensor signals $s_j(t)$ from all of the sensor elements $HE_j$ simultaneously, i.e., each of the acquired sensor signals $s_{j,k}$ relates to the same given time instant $t_k$ at the given prediction cycle $k$ (herein also referred to uniform or simultaneous sampling). To this end, a multichannel analog-to-digital converter ADC is provided. Each channel of the multichannel ADC is connected to a respective one of the sensor elements $HE_j$ to facilitate simultaneous acquisition of all sensor signals $s_j(t)$ at the time instant $t_k$. After the A/D conversion, the multichannel ADC outputs the digital representations of the sensor signals $s_j(t)$ as the acquired sensor signals $s_{j,k}$.

In an alternative embodiment (not shown), a sensor device may comprise a non-uniform or non-simultaneous sampling of the sensor signals $s_j(t)$. In this case, the $N_s$ channels for the sensor signals $s_j(t)$ are multiplexed and discretized in a single-channel ADC to sequentially obtain the signals $s_{j,k}$, $j = 1, ..., N_s$. Each of the $N_s$ sensor signals $s_{j,k}$ is used in turn in a related prediction and correction step sequence as before in the case of the simultaneous sampling approach.

While various examples, embodiments, and aspects have been illustrated and described in detail in the drawings and the foregoing description, such illustration and description are to be considered illustrative or examples and not restrictive.

From reading the present disclosure, other modifications will be apparent to persons skilled in the art. Such modifications may involve other features which are already known in the art and which may be used instead of or in addition to features already described herein.

Variations to the disclosed embodiments can be understood and effected by those skilled in the art from a study of the drawings, the disclosure, and the appended claims. The mere fact that certain measures are recited in different dependent claims does not indicate that a combination of these measures cannot be used to advantage.

Any reference signs in the claims should not be construed as limiting the scope thereof.

**Reference signs**

| | |
|---|---|
| 10 | Sensor device |
| 11 | Electrical conductor |
| 12 | Processing circuit |
| 13 | Region of interest |
| 14 | Longitudinal axis |
| 15 | Sensor device |
| 16 | Sensor device |
| 17 | Symmetry/mirror plane |
| 18 | System state corrector |
| 19 | System state predictor |
| 20 | Delay unit |
| 21 | Sensor signal predictor |
| 30 | Current measuring system |
| 31 | Current measuring system |
| 32 | Current measuring system |

| | |
|---|---|
| ADC | Analog-to-Digital Converter |
| $\mathbf{B}$ | Magnetic field |
| $\mathbf{d}_j$ | Location vector of sensor element j |
| $HE_j$ | Sensor element |
| $I^{meas}$ | Current to be determined |
| k | State update cycle |
| $N_s$ | Number of sensor elements |
| PCB | Circuit board |
| $\hat{\boldsymbol{q}}_{k|k-1}$ | Vector of predicted sensor signals |
| $s_j(t)$ | Continuous time sensor signal |
| $s_{j,k}$ | Discrete time sensor signal |
| $\mathbf{t}$ | Translation vector |
| $\boldsymbol{x}_{k|k}$ | Output value |
| $\boldsymbol{x}_{k|k-1}$ | Predicted output value |
| $\boldsymbol{x}_{k-1|k-1}$ | Previous output value |

| | |
|---|---|
| U | First phase of 3-phase AC current |
| V | Second phase of 3-phase AC current |
| W | Third phase of 3-phase AC current |
| x | First spatial direction |
| y | Second spatial direction |

z   Third spatial direction

$\gamma$   Relative current amplitude

$\theta$   Rotation angle

$\phi$   AC current phase

$\omega$   AC current angular frequency

**Claims**

1. A method of determining a current ($I^{meas}$) flowing in an electrical conductor (11), the method comprising the steps of:

   - providing a number ($N_s$) of magnetic sensor elements ($HE_j$), which are sensitive to a magnetic field (B) generated by the current ($I^{meas}$), at respective sensor locations ($d_j$) relative to a predetermined reference point,
   - outputting, by the magnetic sensor elements ($HE_j$), sensor signals ($s_j(t)$) indicative of a characteristic, e.g., a field component ($B_x$, $B_y$, $B_z$) of the magnetic field (B) at the respective sensor locations ($d_j$),
   - receiving the sensor signals ($s_j(t)$) from the magnetic sensor elements ($HE_j$) by a processing circuit (12),
   - mapping, by the processing circuit (12), the received sensor signals ($s_j(t)$) to an output value ($\boldsymbol{x}_{k|k}$) indicative of the current ($I^{meas}$) flowing in the conductor (11), and
   - outputting the output value ($\boldsymbol{x}_{k|k}$),

   wherein the mapping comprises using, with respect to the predetermined reference point, a multipole expansion of the magnetic field (B) generated by the current ($I^{meas}$), the multipole expansion comprising a predetermined number ($M_m$) of predetermined multipole components ($m^\alpha$) and respectively associated predetermined multipole coefficients ($c_\alpha$).

2. The method according to claim 1, wherein the multipole coefficients ($c_\alpha$) are determined as a solution vector **c** of a linear system of equations **M c = b** given by a system matrix **M** composed of the number ($M_m$) of the multipole components ($m^\alpha$) evaluated at the sensor locations ($d_j$) and by a right-hand side vector **b** formed by the received sensor signals ($s_j(t)$), wherein the linear system of equations is solved by an inverse of the system matrix **M** if the number ($N_s$) of the magnetic sensor elements ($HE_j$) equals the number ($M_m$) of the multipole components ($m^\alpha$), by least squares normal equations if the number ($N_s$) of the magnetic sensor elements ($HE_j$) is greater than the number ($M_m$) of the multipole components ($m^\alpha$), and by choosing a minimal norm solution if the number ($N_s$) of the magnetic sensor elements ($HE_j$) is less than the number ($M_m$) of the multipole components ($m^\alpha$).

3. The method according to claim 1 or 2, wherein the mapping further comprises the step of predicting the sensor signals ($s_{j,k}$) as predicted sensor signals ($\hat{\boldsymbol{q}}_{k|k-1}$) from a previous output value ($\boldsymbol{x}_{k1|k-1}$) using a linear combination of the multipole components ($m^\alpha$) evaluated at the respective sensor locations ($d_j$) and weighted with the respectively associated multipole coefficients ($c_\alpha$), and correcting the output value ($\boldsymbol{x}_{k|k}$) according to a difference between the predicted sensor signals ($\hat{\boldsymbol{q}}_{k|k-1}$) and the received sensor signals ($s_j$).

4. The method according to any of the previous claims, wherein the mapping further comprises a step of determining an actual translational (t) and/or an actual rotational ($\theta$) displacement of the sensor locations ($d_j$) relative to the sensor locations ($d_j$), for example during a calibration phase, and optionally further comprising the step of storing this rotational displacement in a non-volatile memory.

5. The method according to any of the previous claims, wherein the reference point is determined to be located in a symmetry plane (17) of the electrical conductor (11).

6. The method according to any of the previous claims, wherein the sensor locations ($d_j$) are determined such that a spatial distance between at least two of the sensor elements ($HE_j$) is larger than a maximum operational spatial position variation of a relative position between the sensor elements ($HE_j$) and the electrical conductor (11).

7. The method according to any of the previous claims, wherein the sensor locations ($d_j$) are determined to be located in a symmetry plane (17) or to be at symmetry points with respect to a symmetry plane (17) of the electrical conductor (11).

8. The method according to any of the previous claims, wherein the multipole expansion comprises up to a second order maximum.

9.  The method according to any of the previous claims, wherein more than one conductor (11) is provided and determining the current comprises determining individual currents ($I_U^{meas}$, $I_V^{meas}$, $I_W^{meas}$) respectively flowing in each of the conductors (11), wherein for each of the conductors (11) a separate multipole expansion is used.

10. A current sensor device (10, 15, 16) for determining a current ($I^{meas}$) flowing in a conductor (11), comprising:

    - a number ($N_s$) of magnetic sensor elements ($HE_j$) sensitive to a magnetic field (B) generated by the current ($I^{meas}$), wherein each of the magnetic sensor elements ($HE_j$) is arranged at respective sensor locations ($d_j$) relative to a predetermined reference point and configured to respectively output sensor signals ($s_j(t)$) indicative of a field component ($B_x$, $B_y$, $B_z$) of the magnetic field (B) at the respective sensor locations ($d_j$), and
    - a processing circuit (12) configured to receive the sensor signals ($s_j(t)$) from the magnetic sensor elements ($HE_j$),

    wherein the processing circuit (12) is configured to map the received sensor signals ($s_j(t)$) to an output value ($\boldsymbol{x}_{k|k}$) indicative of the current ($I^{meas}$) flowing in the conductor (11), and to output the output value ($\boldsymbol{x}_{k|k}$), wherein the mapping comprises using, with respect to the predetermined reference point, a multipole expansion of the magnetic field (B) generated by the current ($I^{meas}$), the multipole expansion comprising a predetermined number ($M_m$) of predetermined multipole components ($m^\alpha$) and respectively associated predetermined multipole coefficients ($c_\alpha$).

11. The current sensor device according to claim 10, wherein the magnetic sensor elements ($HE_j$) are mounted on a common rigid body (PCB).

12. The current sensor device according to claim 10 or 11, wherein one or more of the magnetic sensor elements ($HE_j$) is/are configured to respectively output a gradient of the magnetic field (B) as the field component ($B_x$, $B_y$, $B_z$) at the respective sensor locations ($d_j$) with respect to a predetermined spatial direction (x, y).

13. A current measuring system (30, 31, 32), comprising at least one electrical conductor (11) and a current sensor device (10, 15, 16) according to any of the claims 10-12 for determining a current ($I^{meas}$) flowing in the at least one electrical conductor (11).

14. The current measuring system according to claim 13, wherein the reference point is determined to be in a plane (17) including a longitudinal axis (14) of the electrical conductor (11).

15. The current measuring system according to claim 13 or 14, comprising more than one conductor (11) and determining the current comprises determining individual currents ($I_U^{meas}$, $I_V^{meas}$, $I_W^{meas}$) respectively flowing in each of the electrical conductors (11), wherein for each of the conductors (11) a separate multipole expansion is used.

**Patentansprüche**

1.  Verfahren zum Ermitteln eines Stroms ($I^{meas}$), der in einem elektrischen Leiter (11) fließt, wobei das Verfahren die folgenden Schritte umfasst:

    - Bereitstellen einer Anzahl ($N_s$) magnetischer Sensorelemente ($HE_j$), die auf ein Magnetfeld (B), das von dem Strom ($I^{meas}$) erzeugt wird, reagieren, an jeweilige Sensororte ($d_j$) relativ zu einem vorbestimmten Referenzpunkt,
    - Ausgeben durch die Magnetsensorelemente ($HE_j$) von Sensorsignalen ($s_j(t)$), die auf ein Merkmal hinweisen, z, B. eine Feldkomponente ($B_x$, $B_y$, $B_z$) des Magnetfeldes (B) an den jeweiligen Sensororten ($d_j$),
    - Empfangen der Sensorsignale ($s_j(t)$) von den Magnetsensorelementen ($HE_j$) durch eine Verarbeitungsschaltung (12),
    - Abbilden durch die Verarbeitungsschaltung (12) der empfangenen Sensorsignale ($s_j(t)$) auf einen Ausgangswert ($x_{k|k}$), der auf den Strom ($I^{meas}$), der in dem Leiter (11) fließt, hinweist, und
    - Ausgeben des Ausgabewerts ($x_{k|k}$), wobei das Abbilden das Verwenden in Bezug auf den vorbestimmten Referenzpunkt einer Multipolexpansion des Magnetfeldes (B), das durch den Strom ($I^{meas}$) erzeugt wird, umfasst, wobei die Multipolexpansion eine vorbestimmte Anzahl ($M_m$) vorbestimmter Multipolkomponenten ($m^\alpha$) und jeweiliger zugeordneter vorbestimmter Multipolkoeffizienten ($c_\alpha$) umfasst.

2. Verfahren nach Anspruch 1, wobei die Multipolkoeffizienten ($c_\alpha$) als ein Lösungsvektor c eines linearen Systems von Gleichungen M c = b bestimmt werden, die von einer Systemmatrix M gegeben werden, die aus der Anzahl ($M_m$) ($M_m$) der Multipolkomponenten ($m^\alpha$) besteht, die an den Sensororten ($d_j$) bewertet werden, und durch einen rechtsseitigen Vektor b, der durch die empfangenen Sensorsignale ($s_j(t)$) gebildet wird, wobei das lineare System von Gleichungen durch eine Umkehrung der Systemmatrix M gelöst wird, wenn die Anzahl ($N_s$) der Magnetsensorelemente ($HE_j$) gleich der Anzahl ($M_m$) der Multipolkomponenten ($m^\alpha$) ist, durch Normalgleichungen der kleinsten Quadrate, wenn die Anzahl ($N_s$) der Magnetsensorelemente ($HE_j$) größer als die Anzahl ($M_m$) der Multipolkomponenten ($m^\alpha$) ist, und durch Auswählen einer minimalen Normlösung, wenn die Anzahl ($N_s$) der Magnetsensorelemente ($HE_j$) kleiner als die Anzahl ($M_m$) der Multipolkomponenten ($m^\alpha$) ist.

3. Verfahren nach Anspruch 1 oder 2, wobei das Abbilden ferner den Schritt des Vorhersagens der Sensorsignale ($s_j$,k) als vorhergesagte Sensorsignale ($\hat{q}_{k|k-1}$) aus einem vorherigen Ausgabewert ($x_{k-1|k-1}$) unter Verwendung einer linearen Kombination von Multipolkomponenten ($m^\alpha$), die an den jeweiligen Sensororten ($d_j$) bewertet und mit den jeweiligen zugeordneten Multipolkoeffizienten ($c_\alpha$) gewichtet werden, und Korrigieren des Ausgabewerts ($x_{k|k}$) gemäß einer Differenz zwischen den vorhergesagten Sensorsignalen ($\hat{q}_{k|k-1}$) und den empfangenen Sensorsignalen ($s_j$).

4. Verfahren nach einem der vorstehenden Ansprüche, wobei das Abbilden ferner einen Schritt des Bestimmens einer tatsächlichen Translationsverschiebung (t) und/oder einer tatsächlichen Rotationsverschiebung ($\theta$) der Sensororte ($d_j$) relativ zu den Sensororten ($d_j$) umfasst, beispielsweise während einer Kalibrierungsphase und optional ferner den Schritt des Speicherns dieser Rotationsverschiebung in einem nichtflüchtigen Arbeitsspeicher umfasst.

5. Verfahren nach einem der vorstehenden Ansprüche, wobei der Referenzpunkt als in einer Symmetrieebene (17) des elektrischen Leiters (11) befindlich bestimmt wird.

6. Verfahren nach einem der vorstehenden Ansprüche, wobei die Sensororte ($d_j$) derart bestimmt werden, dass eine räumliche Entfernung zwischen mindestens zwei der Sensorelementen ($HE_j$) größer ist als eine maximale betriebliche räumliche Positionsvariation einer relativen Position zwischen den Sensorelementen ($HE_j$) und dem elektrischen Leiter (11).

7. Verfahren nach einem der vorstehenden Ansprüche, wobei die Sensororte ($d_j$) als in einer Symmetrieebene (17) oder an Symmetriepunkten in Bezug auf eine Symmetrieebene (17) des elektrischen Leiters (11) befindlich bestimmt werden.

8. Verfahren nach einem der vorstehenden Ansprüche, wobei die Multipolexpansion bis zu einem Maximum zweiter Ordnung umfasst.

9. Verfahren nach einem der vorstehenden Ansprüche, wobei mehr als ein Leiter bereitgestellt wird und das Bestimmen des Stroms das Bestimmen individueller Ströme ($I_U^{meas}$, $I_V^{meas}$, $I_W^{meas}$), die jeweils in jedem der Leiter (11) fließen, umfasst, wobei für jeden der Leiter (11) eine separate Multipolexpansion verwendet wird.

10. Stromsensorvorrichtung (10, 15, 16) zum Bestimmen eines Stroms ($I^{meas}$), der in einem Leiter (11) fließt, die Folgendes umfasst:

    - eine Anzahl ($N_s$) von Magnetsensorelementen ($HE_j$), die auf ein Magnetfeld (B) reagieren, das von dem Strom ($I^{meas}$) erzeugt wird, wobei jedes der Magnetsensorelemente ($HE_j$) an jeweiligen Sensororten ($d_j$) relativ zu einem vorbestimmten Referenzpunkt eingerichtet und jeweils dazu konfiguriert ist, Sensorsignale ($s_j(t)$) auszugeben, die auf eine Feldkomponente ($B_x$, $B_y$, $B_z$) des Magnetfeldes (B) an den jeweiligen Sensororten ($d_j$) hinweisen, und
    - eine Verarbeitungsschaltung (12), die dazu konfiguriert ist, die Sensorsignale ($s_j(t)$) von den Magnetsensorelementen ($HE_j$) zu empfangen,

wobei die Verarbeitungsschaltung (12) dazu konfiguriert ist, die empfangenen Sensorsignale ($s_j(t)$) auf einen Ausgangswert ($x_{k|k}$), der auf den Strom ($I^{meas}$), der in dem Leiter (11) fließt, und den Ausgabewert ($x_{k|k}$) hinweist, abzubilden, wobei das Abbilden die Verwendung in Bezug auf den vorbestimmten Referenzpunkt einer Multipolexpansion des Magnetfeldes (B) umfasst, das von dem Strom ($I^{meas}$) erzeugt wird, wobei die Multipolexpansion eine vorbestimmte Anzahl ($M_m$) vorbestimmter Multipolkomponenten ($m^\alpha$) und jeweils zugeordneter vorbestimmter Multipolkoeffizienten ($c_\alpha$) umfasst.

**11.** Stromsensorvorrichtung nach Anspruch 10, wobei die Magnetsensorelemente (HE$_j$) auf einen gemeinsamen starren Körper (PCB) montiert sind.

**12.** Stromsensorvorrichtung nach Anspruch 10 oder 11, wobei ein oder mehrere der Magnetsensorelemente (HE$_j$) dazu konfiguriert ist/sind, jeweils einen Gradienten des Magnetfeldes (B) als die Feldkomponente (B$_x$, B$_y$, B$_z$) an den jeweiligen Sensororten (d$_j$) in Bezug auf eine vorbestimmte räumliche Richtung (x, y) auszugeben.

**13.** Strommesssystem (30, 31, 32), das mindestens einen elektrischen Leiter (11) und eine Stromsensorvorrichtung (10, 15, 16) nach einem der Ansprüche 10-12 zum Bestimmen eines Stroms (I$^{meas}$), der in dem mindestens einen elektrischen Leiter (11) fließt, umfasst.

**14.** Strommesssystem nach Anspruch 13, wobei der Referenzpunkt als in einer Ebene (17), die eine Längsachse (14) des elektrischen Leiters (11) einschließt, befindlich bestimmt wird.

**15.** Strommesssystem nach Anspruch 13 oder 14, das mehr als einen Leiter (11) umfasst und das Bestimmen des Stroms das Bestimmen individueller Ströme (I$_U^{meas}$, I$_V^{meas}$, I$_W^{meas}$), die jeweils in jedem der Leiter (11) fließen, umfasst, wobei für jeden der elektrischen Leiter (11) eine separate Multipolexpansion verwendet wird.

**Revendications**

**1.** Procédé pour déterminer un courant (I$^{meas}$) circulant dans un conducteur électrique (11), le procédé comprenant les étapes comprenant le fait de :

- fournir un nombre (N$_s$) d'éléments de capteurs magnétiques (HE$_j$), qui sont sensibles à un champ magnétique (B) généré par le courant (I$^{meas}$), à des emplacements de capteurs respectifs (d$_j$) par rapport à un point de référence prédéterminé,
- fournir en sortie, par le biais des éléments de capteurs magnétiques (HE$_j$), des signaux de capteur (s$_j$(t)) indicatifs d'une caractéristique, par exemple une composante de champ (B$_x$, B$_y$, B$_z$) du champ magnétique (B) aux emplacements de capteurs respectifs (d$_j$),
- recevoir les signaux de capteurs (s$_j$(t)) en provenance des éléments de capteurs magnétiques (HE$_j$) par le biais d'un circuit de traitement (12),
- mettre en correspondance, par le biais du circuit de traitement (12), les signaux de capteurs reçus (s$_j$(t)), avec une valeur de sortie ($x_{k|k}$) indicative du courant (I$^{meas}$) circulant dans le conducteur (11), et
- fournir en sortie la valeur de sortie ($x_{k|k}$),

dans lequel la mise en correspondance comprend le fait d'utiliser, par rapport au point de référence prédéterminé, une expansion multipolaire du champ magnétique (B) généré par le courant (I$^{meas}$), l'expansion multipolaire comprenant un nombre prédéterminé (M$_m$) de composantes multipolaires prédéterminées (m$^\alpha$) et de coefficients multipolaires prédéterminés (c$_\alpha$) respectivement associés.

**2.** Procédé selon la revendication 1, dans lequel les coefficients multipolaires (c$_\alpha$) sont déterminés comme un vecteur de solution **c** d'un système d'équations linéaire **M c = b** donné par une matrice système **M** composée du nombre (M$_m$) des composantes multipolaires (m$^\alpha$) évaluées aux emplacements de capteurs (d$_j$), et par un vecteur côté droit **b** formé par les signaux de capteurs reçus (s$_j$(t)), dans lequel le système d'équations linéaire est résolu par une inverse de la matrice système **M** si le nombre (N$_s$) des éléments de capteurs magnétiques (HE$_j$) est égal au nombre (M$_m$) des composantes multipolaires (m$^\alpha$), par des équations normales des moindres carrés si le nombre (N$_s$) des éléments de capteurs magnétiques (HE$_j$) est supérieur au nombre (M$_m$) des composantes multipolaires (m$^\alpha$), et en choisissant une solution de norme minimale si le nombre (N$_s$) des éléments de capteurs magnétiques (HE$_j$) est inférieur au nombre (M$_m$) des composantes multipolaires (m$^\alpha$).

**3.** Procédé selon la revendication 1 ou 2, dans lequel la mise en correspondance comprend en outre l'étape consistant à prédire les signaux de capteurs (s$_{j,k}$) en tant que des signaux de capteurs prédits ($\hat{q}_{k|k-1}$), à partir d'une valeur de sortie précédente ($x_{k-1|k-1}$), en utilisant une combinaison linéaire des composantes multipolaires (m$^\alpha$) évaluées aux emplacements de capteurs respectifs (d$_j$) et pondérées par les coefficients multipolaires (c$_\alpha$) respectivement associés, et à corriger la valeur de sortie ($x_{k|k}$) en fonction d'une différence entre les signaux de capteurs prédits ($\hat{q}_{k|k-1}$) et les signaux de capteurs reçus (s$_j$).

4. Procédé selon l'une quelconque des revendications précédentes, dans lequel la mise en correspondance comprend en outre une étape consistant à déterminer un déplacement translationnel réel (t) et/ou un déplacement rotationnel réel ($\theta$) des emplacements de capteurs ($d_j$) par rapport aux emplacements de capteurs ($d_j$), par exemple pendant une phase d'étalonnage, et comprenant éventuellement en outre l'étape consistant à stocker ce déplacement rotationnel dans une mémoire non volatile.

5. Procédé selon l'une quelconque des revendications précédentes, dans lequel le point de référence est déterminé comme étant situé dans un plan de symétrie (17) du conducteur électrique (11).

6. Procédé selon l'une quelconque des revendications précédentes, dans lequel les emplacements de capteurs ($d_j$) sont déterminés de sorte qu'une distance spatiale entre au moins deux des éléments de capteurs ($HE_j$) est supérieure à une variation de position spatiale opérationnelle maximale d'une position relative entre les éléments de capteurs ($HE_j$) et le conducteur électrique (11).

7. Procédé selon l'une quelconque des revendications précédentes, dans lequel les emplacements de capteurs ($d_j$) sont déterminés comme étant situés dans un plan de symétrie (17) ou comme étant à des points de symétrie par rapport à un plan de symétrie (17) du conducteur électrique (11).

8. Procédé selon l'une quelconque des revendications précédentes, dans lequel l'expansion multipolaire comprend jusqu'à un maximum du deuxième ordre.

9. Procédé selon l'une quelconque des revendications précédentes, dans lequel plus d'un conducteur (11) est fourni, et la détermination du courant comprend le fait de déterminer des courants individuels ($I_U^{meas}$, $I_V^{meas}$, $I_W^{meas}$) circulant respectivement dans chacun des conducteurs (11), dans lequel, pour chacun des conducteurs (11), une expansion multipolaire distincte est utilisée.

10. Dispositif de capteurs de courant (10, 15, 16) pour déterminer un courant ($I^{meas}$) circulant dans un conducteur (11), comprenant :

   - un nombre ($N_s$) d'éléments de capteurs magnétiques ($HE_j$) sensibles à un champ magnétique (B) généré par le courant ($I^{meas}$), dans lequel chacun des éléments de capteurs magnétiques ($HE_j$) est agencé à des emplacements de capteurs respectifs ($d_j$) par rapport à un point de référence prédéterminé, et est configuré pour fournir en sortie respectivement des signaux de capteurs ($s_j(t)$) indicatifs d'une composante de champ ($B_x$, $B_y$, $B_z$) du champ magnétique (B) aux emplacements de capteurs respectifs ($d_j$), et
   - un circuit de traitement (12) configuré pour recevoir les signaux de capteurs ($s_j(t)$) en provenance des éléments de capteurs magnétiques ($HE_j$),

   dans lequel le circuit de traitement (12) est configuré pour mettre en correspondance les signaux de capteurs reçus ($s_j(t)$) avec une valeur de sortie ($\boldsymbol{x}_{k|k}$) indicative du courant ($I^{meas}$) circulant dans le conducteur (11), et pour fournir en sortie la valeur de sortie ($\boldsymbol{x}_{k|k}$), dans lequel la mise en correspondance comprend le fait d'utiliser, par rapport au point de référence prédéterminé, une expansion multipolaire du champ magnétique (B) généré par le courant ($I^{meas}$), l'expansion multipolaire comprenant un nombre prédéterminé ($M_m$) de composantes multipolaires prédéterminées ($m^\alpha$) et de coefficients multipolaires prédéterminés ($c_\alpha$) respectivement associés.

11. Dispositif de capteurs de courant selon la revendication 10, dans lequel les éléments de capteurs magnétiques ($HE_j$) sont montés sur un corps rigide commun (PCB).

12. Dispositif de capteurs de courant selon la revendication 10 ou 11, dans lequel un ou plusieurs des éléments de capteurs magnétiques ($HE_j$) est/sont configuré(s) pour fournir en sortie respectivement un gradient du champ magnétique (B) en tant que la composante de champ ($B_x$, $B_y$, $B_z$) aux emplacements de capteurs respectifs ($d_j$) par rapport à une direction spatiale prédéterminée (x, y).

13. Système de mesure de courant (30, 31, 32), comprenant au moins un conducteur électrique (11) et un dispositif de capteurs de courant (10, 15, 16) selon l'une quelconque des revendications 10 à 12, pour déterminer un courant ($I^{meas}$) circulant dans l'au moins un conducteur électrique (11).

14. Système de mesure de courant selon la revendication 13, dans lequel le point de référence est déterminé comme étant dans un plan (17) comprenant un axe longitudinal (14) du conducteur électrique (11).

15. Système de mesure de courant selon la revendication 13 ou 14, comprenant plus d'un conducteur (11), et dans lequel la détermination du courant comprend le fait de déterminer des courants individuels ($I_U{}^{meas}$, $I_V{}^{meas}$, $I_W{}^{meas}$) circulant respectivement dans chacun des conducteurs (11), dans lequel, pour chacun des conducteurs (11), une expansion multipolaire distincte est utilisée.

$$\mathbf{B}(\mathbf{d}_j) = \sum_{\alpha=1}^{M_m} \mathbf{m}^\alpha(\mathbf{d}_j) \cdot c_\alpha$$

FIG. 1

FIG. 2

FIG. 3

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170184635 A1

**Non-patent literature cited in the description**

- Circular Arrays of Magnetic Sensors for Current Measurement. **RIENZO et al.** IEEE TRANSACTIONS ON INSTRUMENTATION AND MEASUREMENT. IEEE, 01 October 2001, vol. 50